(19) Europäisches Patentamt
European Patent Office
Office européen des brevets

(11) **EP 1 056 208 B1**

(12) **FASCICULE DE BREVET EUROPEEN**

(45) Date de publication et mention
de la délivrance du brevet:
**21.09.2005 Bulletin 2005/38**

(51) Int Cl.⁷: **H03M 1/06**

(21) Numéro de dépôt: **00401337.1**

(22) Date de dépôt: **16.05.2000**

(54) **Dispositif compensateur de la non-linéarité d'un convertisseur analogue-numérique**

Anordnung zur Ausgleichung der Nichtlinearität eines A/D Wandlers

A/D converter non-linearity compensating device

(84) Etats contractants désignés:
**AT BE CH CY DE DK ES FI FR GB GR IE IT LI LU MC NL PT SE**

(30) Priorité: **28.05.1999 FR 9906793**

(43) Date de publication de la demande:
**29.11.2000 Bulletin 2000/48**

(73) Titulaire: **Thales**
**75008 Paris (FR)**

(72) Inventeurs:
• **Berranger, Robert,**
**Thomsom-CSF P.I.Dépt. Brevets**
**94117 Arcueil Cedex (FR)**

• **De Gouy, Jean-Luc,**
**Thomsom-CSF P.I.Dépt. Brevets**
**94117 Arcueil Cedex (FR)**

(74) Mandataire: **Desperrier, Jean-Louis et al**
**Thomson-CSF Propriété Intellectuelle,**
**13, Avenue du Président Salvador Allende**
**94117 Arcueil Cédex (FR)**

(56) Documents cités:
**GB-A- 2 235 599        US-A- 4 937 576**
**US-A- 5 525 984**

• **J. EPSTEIN: "Hardware Design for a Dynamic Signal Analyzer" HEWLETT-PACKARD JOURNAL., vol. 35, no. 12, décembre 1984 (1984-12), pages 12-17, XP002128095 HEWLETT-PACKARD CO. PALO ALTO., US**

## Description

La présente invention concerne un dispositif compensateur de la non-linéarité d'un convertisseur analogique-numérique. Elle s'applique à la réalisation de récepteurs numériques de communications.

Une caractéristique importante des récepteurs radio est leur aptitude à démoduler des signaux faibles en présence de signaux perturbateurs d'amplitude élevée. Cette aptitude est qualifiée par une dynamique instantanée et se mesure en décibels.

Dans les récepteurs analogiques, la dynamique instantanée est obtenue par filtrage en bande étroite en amont de la chaîne d'amplification et peut atteindre 120 dB.

Par principe, les récepteurs numériques large bande ne disposent pas de filtres à bande de fréquence étroite placés devant le convertisseur analogique-numérique, ce qui a pour effet de diminuer fortement la dynamique des récepteurs et de provoquer des distorsions sur le signal démodulé.

La dynamique des convertisseurs analogique-numérique utilisés est de l'ordre de 70 dB. Leur dynamique de bruit qui est désignée en anglais sous l'abréviation S.F.D.R de « Spurious Free Dynamic Range « est de 80 dB relativement à la pleine échelle notée PE du convertisseur. Cette dynamique varie en fonction du niveau du signal appliqué sur le convertisseur, par exemple, pour des signaux à -20 dB de la pleine échelle, la dynamique est réduite de 20 dB.

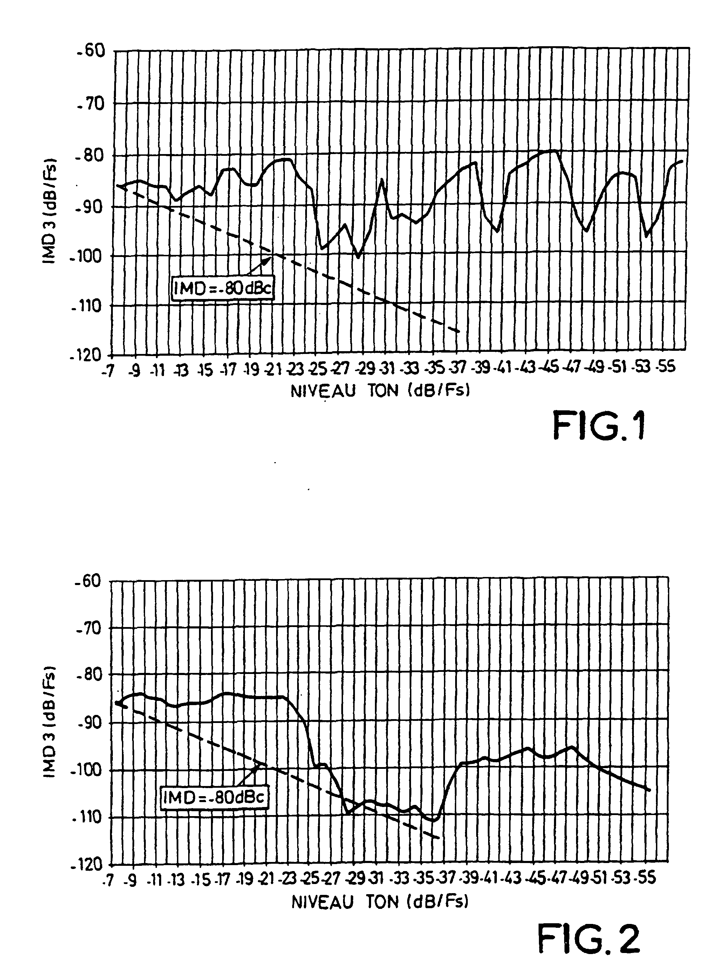

Les distorsions du signal démodulé sont produites par le fait de l'imprécision de la conversion, les pas d'un convertisseur n'ayant pas tous la même valeur analogique. Les écarts d'un pas à un autre peuvent en effet atteindre plus ou moins 50%. Cette non-linéarité qui porte le nom dans la littérature de « linéarité différentielle » est qualifiée de « rugueuse » par opposition à la non-linéarité des circuits analogiques qui est lisse. Pour un convertisseur analogique-numérique il y a en réalité une multitude de courbes de non-linéarités différentielles du type de celle de la figure 1 qui représente une courbe de distorsion d'intermodulation en deux tons égaux en fonction du niveau du signal appliqué sur l'entrée d'un convertisseur analogique-numérique, qui dépendent à la fois de la fréquence absolue du signal et de son rapport avec la fréquence d'horloge.

Une méthode connue pour compenser la non-linéarité d'un convertisseur numérique-analogique consiste à ajouter au signal appliqué sur rentrée du convertisseur un signal de bruit, appelé « dither » en anglais, ayant des caractéristiques particulières. L'efficacité de la méthode n'est pas optimale pour corriger la non-linéarité de convertisseurs analogiques-numériques de récepteurs radio numériques à large bande de fréquence s'étendant sur quelques dizaines de MHz et à faible bande de fréquence de modulation de quelques dizaines de kHz. Ainsi par exemple, en ajoutant un signal de bruit (dither) à -35 dB/PE en puissance moyenne, la courbe de distorsion de la figure 1 se trouve être améliorée comme l'indique la figure 2, pour les niveaux de crête compris entre -10 dB/PE et -25 dB/PE, cette amélioration étant encore plus nette pour les niveaux inférieurs. Il apparaît également que la rugosité a diminué. Cependant l'intermodulation d'ordre 3 (IMD3) reste toujours inférieure à -80dBc.

Une observation encore plus fine de la courbe de la figure 2 fait apparaître que pour bénéficier de la linéarité maximum il y aurait intérêt à positionner le signal brouilleur à la pleine échelle du convertisseur ce qui amènerait à augmenter le gain d'environ 20 dB dans la partie analogique du récepteur située avant le convertisseur, bien que ceci ne soit pas justifié par le plancher de bruit du convertisseur et puisse entraîner une instabilité du récepteur par l'accroissement qui en résulte de la dynamique de la boucle analogique de contrôle automatique de gain (CAG) placée devant le convertisseur. Mais du fait de la gestion par pas de la boucle de CAG et de l'hystérésis nécessaire, il est pratiquement impossible de positionner le signal au-dessus d'une fenêtre entre 3 dB et -8 dB de la pleine échelle ce qui représente autant de perte pour la dynamique instantanée. Enfin, le fait de positionner les brouilleurs naturels au maximum de la pleine échelle ne laisse aucune marge et les bruits impulsifs sont écrêtés par le convertisseur avec les désagréments qui en résultent.

Le but de l'invention est de pallier les inconvénients précités.

Le brevet US A 5525984 divulgue un système de conversion analogique numérique comportant un étage brouilleur fournissant à sa sortie un signal brouilleur d'amplitude constante modulé en fréquence par du bruit qui est ajouté au signal appliqué sur l'entrée du convertisseur. L'étage brouilleur comprend un oscillateur à fréquence variable modulé en fréquence par le bruit blanc fourni par un générateur de bruit, le signal résultant étant passé par un modulateur en amplitude en circuit additionneur.

A cet effet, l'invention a pour objet, un procédé de linéarisation d'un convertisseur analogique-numérique caractérisé en ce qu'il comporte au moins une étape où un signal brouilleur d'amplitude constante modulé en fréquence par du bruit est ajouté au signal appliqué sur l'entrée du convertisseur et en ce qu'il comporte une <u>étape d'asservissement de l'amplitude du signal brouilleur en fonction de l'amplitude du signal analogique à convertir, pour que le niveau du signal d'entrée ajouté au niveau du signal de sortie de l'étage brouilleur soit égal au niveau de signal pleine échelle du convertisseur-analogique-numérique.</u>

Selon une deuxième caractéristique le procédé selon l'invention comporte également une étape d'asservissement du niveau du brouilleur ajouté sur le signal appliqué à l'entrée du convertisseur de façon que le niveau résultant soit égal à la pleine échelle du convertisseur.

L'invention a également pour objet un dispositif pour la mise en oeuvre du procédé précité.

Le procédé et le dispositif selon l'invention ont pour avantage d'apporter une solution à la linéarisation des récepteurs numériques lorsque la linéarité dépend de celle du convertisseur analogique-numérique. Le procédé mis en oeuvre par l'invention a un caractère universel dans la mesure où il peut s'appliquer à toutes sortes de convertisseur analogique- numérique.

D'autres caractéristiques et avantages de l'invention apparaîtront dans la description qui suit faite en regard des dessins annexés qui représentent :

La figure 1 une courbe montrant les fluctuations du niveau d'intermodulation d'ordre 3 en fonction du niveau des tons sans correction par adjonction d'un bruit selon l'art antérieur.

La figure 2 une courbe de fluctuation du niveau d'intermodulation d'ordre 3 obtenu en ajoutant au signal appliqué sur l'entrée du convertisseur un bruit hors la bande de fréquence du signal utile selon l'art antérieur.

La figure 3 deux courbes représentatives du niveau S.F.D.R en fonction du niveau du signal d'entrée appliqué sur le convertisseur obtenue sans linéarisation ou avec linéarisation selon l'invention.

La figure 4 un mode de réalisation d'un dispositif de linéarisation selon l'invention.

Pour faire en sorte que la somme des signaux brouilleurs se retrouvent équirépartis sur l'ensemble de l'échelle d'un convertisseur analogique-numérique afin de lisser les non-linéarités de ce dernier, le procédé selon l'invention consiste à ajouter un brouilleur supplémentaire d'amplitude telle que le niveau du signal utile superposé aux brouilleurs naturels et rajouté au niveau de signal brouilleur ajouté, corresponde à la pleine échelle du convertisseur analogique-numérique. Le spectre du signal brouilleur ajouté est celui d'un bruit blanc ce qui le rend complètement décorrélé, à la fois du signal utile et des brouilleurs naturels, sa largeur étant au moins égale à celle de ces derniers.

Cette solution permet de ramener les raies limitant la dynamique de bruit SFDR à un niveau relatif correspondant à celui de la pleine échelle. La dynamique SFDR peut encore être augmentée par effet d'étalement des raies obtenue en élargissant la bande de bruit du brouilleur ajouté. Ceci se paie par une légère remontée du bruit plancher, ce qui n'est pas gênant tant que celui-ci se trouve en dessous du bruit SFDR. Les résultats obtenus seront alors d'autant plus bénéfiques que le niveau du signal du brouilleur ajouté est prépondérant à l'entrée du convertisseur analogique-numérique. Comme il est également nécessaire d'augmenter la dynamique pour des niveaux élevés des brouilleurs naturels et suffisamment élevés au-dessus du bruit du convertisseur analogique numérique il est possible de trouver des niveaux optima pour les deux types de brouilleurs en positionnant la CAG.

En prenant par exemple, le cas d'un convertisseur analogique-numérique de 80 dB de dynamique de bruit SFDR et de 68 dB de rapport signal à bruit SNR, échantillonné à 65 MHz, le bruit ramené dans une bande de fréquence de 3 kHz est alors égal à :

$$- 68 - 10 \text{ LOG } [\frac{65000}{3}] = -111 \text{ dB pleine échelle.}$$

Pour des brouilleurs naturels à -20 dB de la pleine échelle (10%) le brouilleur ajouté sera à -1dB de la pleine échelle (80 %). La dynamique (brouilleurs naturels/bruit) sera alors de -20 - (-111)= 91 dB.

Pour obtenir ce résultat la bande de fréquence du brouilleur ajouté doit être égale au moins à 10 fois celle du brouilleur naturel.

Dans l'hypothèse où la bande du brouilleur naturel est de 3 kHz ce qui correspond à celle de la majorité des signaux d'entrée dans la gamme HF, cela conduit à utiliser un brouilleur ajouté occupant une bande de fréquence de 30 kHz minimum.

L'ensemble des considérations précédentes amène le procédé selon l'invention à respecter les trois critères suivants à savoir que :

a)- pour travailler en permanence à la pleine échelle du convertisseur analogique-numérique le brouilleur ajouté doit être de préférence asservi sur le niveau provenant de l'entrée du récepteur et ce, avec une bande passante de l'asservissement au moins égale à celle de la modulation,

b) - le brouilleur ajouté doit être à amplitude constante pour ne pas écrêter sur des pointes de bruit, et diminuer le rapport signal à bruit SNR du convertisseur analogique-numérique ce qui conduit à utiliser une porteuse modulée en fréquence par du bruit blanc,

c)- la bande de fréquence du brouilleur ajouté doit être en dehors de la bande utile et suffisamment filtrée pour ne pas déborder sur celle-ci avec un niveau supérieur au bruit du convertisseur analogique numérique, soit à -110 dB dans l'exemple précédent.

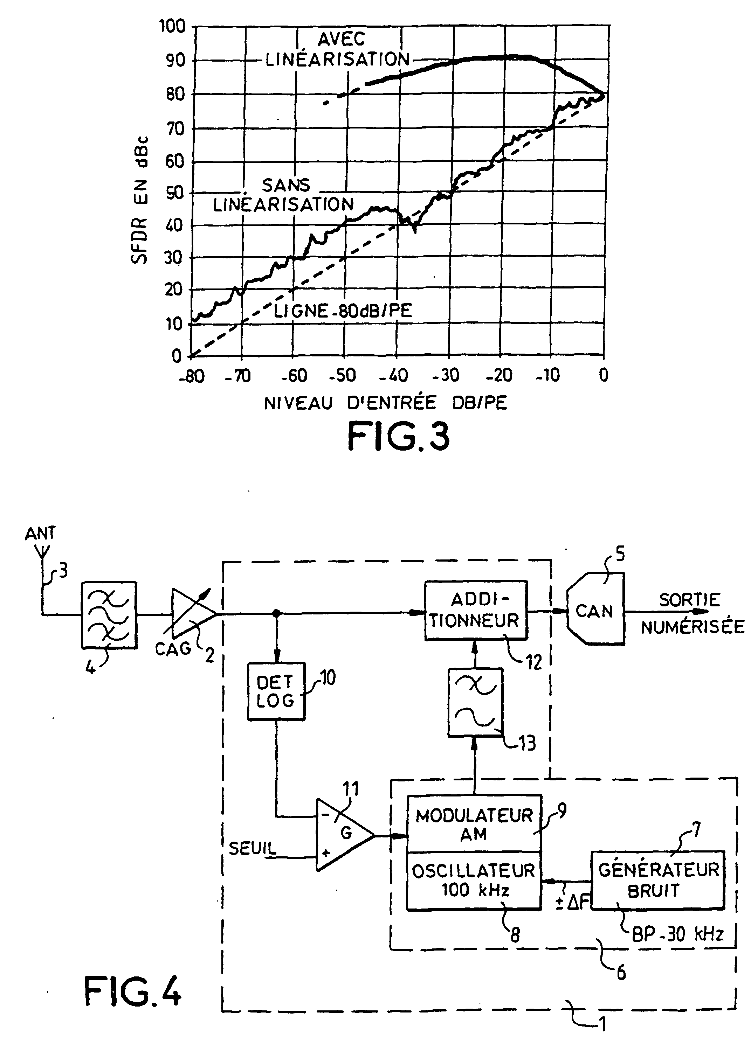

Les courbes de la figure 3 font apparaître les résultats qui peuvent être obtenus en appliquant le procédé selon l'invention pour la linéarisation d'un convertisseur analogique-numérique du type connu sous la référence AD6640 commercialisé par la société de droit des Etats-Unis " ANALOG DEVICES".

Un dispositif pour la mise en oeuvre du procédé selon l'invention respectant les trois critères précédents est représenté sur la figure 4 à l'intérieur d'une ligne fermée en pointillés 1 inséré dans la chaîne de réception d'un récepteur radio entre d'une part, la sortie d'un amplificateur de réception 2 recevant les signaux d'une antenne 3 au travers d'un filtre de bande 4 et d'autre part, d'un convertisseur analogique-numérique 5.

Le dispositif 1 comprend un étage brouilleur 6 représenté également à l'intérieur d'une ligne fermée en pointillés, composé d'un générateur de bruit 7, d'un oscillateur à fréquence variable 8 et d'un étage de modulation en amplitude 9. La fréquence de l'oscillateur 8 est modulée en fréquence par le bruit blanc fourni par le générateur de bruit 7, et le niveau du signal résultant fourni par l'oscillateur 8 est modulé en amplitude par l'étage de modulation 9 en fonction du niveau du signal obtenu à la sortie de l'amplificateur de réception 2. Le niveau de sortie de l'amplificateur de réception 2 est appliqué à l'étage de modulation 9 au travers d'une cellule de détection 10 et d'un amplificateur différentiel 11. Un circuit additionneur 12 effectue l'addition du signal obtenu à la sortie de l'amplificateur de réception 2 avec le niveau de bruit modulé par le dispositif de modulation 9 et filtré au travers d'un filtre passe-bas 13 interposé entre la sortie du dispositif de modulation 9 et l'additionneur 12. Le signal issu du circuit additionneur 12 est ensuite transmis au convertisseur analogique-numérique 5.

Suivant un autre mode de réalisation de l'invention il pourra aussi être envisagé de ne pas asservir le brouilleur ajouté en le positionnant seulement par exemple à 30% de la valeur pleine échelle du convertisseur analogique-numérique. La dynamique totale sera alors réduite de 3 dB et le gain en linéarité sera moins important mais cette disposition pourra encore convenir à de nombreux cas.

## Revendications

1. Procédé de linéarisation d'un convertisseur analogique-numérique (5) comprenant une étape où un signal brouilleur d'amplitude constante modulé en fréquence par du bruit est ajouté au signal appliqué sur l'entrée du convertisseur (5) **caractérisé en ce qu'**il comporte une étape d'asservissement de l'amplitude du signal brouilleur en fonction de l'amplitude du signal analogique à convertir, pour que le niveau du signal d'entrée ajouté au niveau du signal de sortie de l'étage brouilleur (6) soit égal au niveau de signal pleine échelle du convertisseur-analogique-numérique (5).

2. Procédé selon la revendication 1 **caractérisé en ce que** la bande de fréquence du signal brouilleur ajoutée est située en dehors de la bande utile du signal appliqué sur l'entrée du concertisseur (5).

3. Dispositif de linéarisation d'un convertisseur analogique-numérique (5) comprenant un circuit additionneur (12) couplé par une première entrée à la sortie d'un étage brouilleur (6) recevant sur une deuxième entrée le signal analogique à convertir **caractérisé en ce qu'**il comporte au moins un circuit de commande (11) de l'amplitude du signal de sortie de l'étage brouilleur (6) en fonction de l'amplitude du signal analogique à convertir, pour que le niveau du signal d'entrée ajouté au niveau du signal de sortie de l'étage brouilleur (6) soit égal au niveau de signal pleine échelle du convertisseur-analogique-numérique (5).

4. Dispositif selon la revendication 3 **caractérisé en ce que** l'étage brouilleur (6) comprend un générateur de bruit blanc (7), couplé à un étage de modulation (9) au travers d'un oscillateur à fréquence variable (8), **en ce que** d'une part, l'oscillateur (8) est modulé en fréquence par le bruit blanc fourni par le générateur de bruit (7), et d'autre part, le signal de sortie de l'étage de modulation (9) forme le signal de sortie de l'étage brouilleur (6) et est modulé en amplitude en fonction du niveau du signal d'entrée par le circuit de commande (11).

5. Utilisation du procédé selon l'une des revendications 1 à 2 ou du dispositif selon l'une des revendications 3 et 4 dans la chaîne de réception d'un récepteur radio pour la conversion du signal analogique reçu en un signal numérique.

## Patentansprüche

1. Verfahren zur Linearisierung eines Analog-Digital-Wandlers (5), das einen Schritt aufweist, in dem ein mit Rauschen frequenzmoduliertes Störsignal mit konstanter Amplitude zu dem Signal hinzugefügt wird, das an den Eingang des Wandlers (5) angelegt wird, **dadurch gekennzeichnet, dass** es einen Schritt der Regelung der Amplitude des Störsignals in Abhängigkeit von der Amplitude des umzuwandelnden analogen Signals aufweist, damit der Pegel des Eingangssignals, der zum Pegel des Ausgangssignals der Störstufe (6) hinzugefügt wird, gleich dem Vollbereich-Signalpegel des Analog-Digital-Wandlers (5) ist.

2. Verfahren nach Anspruch 1, **dadurch gekennzeichnet, dass** das hinzugefügte Frequenzband des Störsignals sich außerhalb des Nutzbands des an den Eingang des Wandlers (5) angelegten Signals befindet.

3. Vorrichtung zur Linearisierung eines Analog-Digital-Wandlers (5), die eine Addierschaltung (12) aufweist, die über einen ersten Eingang an den Ausgang einer Störstufe (6) gekoppelt ist, die an einem zweiten Eingang das umzuwandelnde analoge Signal empfängt, **dadurch gekennzeichnet, dass** sie mindestens eine Schaltung (11) zur Steuerung der Amplitude des Ausgangssignals der Störstufe (6) in Abhängigkeit von der Amplitude des umzuwandelnden Analogsignals aufweist, damit der Pegel des zum Pegel des Ausgangssignals der Störstufe (6) hinzugefügten Eingangssignals gleich dem Vollbereich-Signalpegel des Analog-Digital-Wandlers (5) ist.

**4.** Vorrichtung nach Anspruch 3, **dadurch gekennzeichnet, dass** die Störstufe (6) einen Generator (7) für weißes Rauschen aufweist, der mit einer Modulationsstufe (9) über einen Oszillator (8) mit variabler Frequenz gekoppelt ist, dass einerseits der Oszillator (8) mit dem vom Rauschgenerator (7) gelieferten weißen Rauschen frequenzmoduliert wird, und dass andererseits das Ausgangssignal der Modulationsstufe (9) das Ausgangssignal der Störstufe (6) bildet und in Abhängigkeit vom Pegel des Eingangssignals von der Steuerschaltung (11) amplitudenmoduliert wird.

**5.** Verwendung des Verfahrens nach einem der Ansprüche 1 bis 2 oder der Vorrichtung nach einem der Ansprüche 3 und 4 in der Empfangskette eines Funkempfängers für die Umwandlung des empfangenen analogen Signals in ein digitales Signal.

**Claims**

**1.** Method of linearizing an analog/digital converter (5) comprising a step where a jammer signal of constant amplitude, frequency-modulated by noise, is added to the signal applied to the input of the converter (5), **characterized in that** it comprises a step of feedback control of the amplitude of the jammer signal as a function of the amplitude of the analog signal to be converted, so that the level of the input signal added to the level of the output signal of the jammer stage (6) is equal to the full-scale signal level of the analog/digital converter (5).

**2.** Method according to Claim 1, **characterized in that** the added frequency band of the jammer signal is situated outside the useful band of the signal applied to the input of the converter (5).

**3.** Device for linearizing an analog/digital converter (5) comprising an adder circuit (12) coupled by a first input to the output of a jammer stage (6) receiving on a second input the analog signal to be converted, **characterized in that** it comprises at least one control circuit (11) for controlling the amplitude of the output signal from the jammer stage (6) as a function of the amplitude of the analog signal to be converted, so that the level of the input signal added to the level of the output signal of the jammer stage (6) is equal to the full-scale signal level of the analog/digital converter (5).

**4.** Device according to Claim 3, **characterized in that** the jammer stage (6) comprises a white noise generator (7), coupled to a modulation stage (9) through a variable-frequency oscillator (8), **in that** on the one hand, the oscillator (8) is frequency-modulated by the white noise provided by the noise generator (7), and on the other hand, the output signal from the modulation stage (9) forms the output signal of the jammer stage (6) and is amplitude-modulated as a function of the level of the input signal by the control circuit (11).

**5.** Use of the method according to either of Claims 1 and 2 or of the device according to either of Claims 3 and 4 in the reception chain of a radio receiver for the conversion of the analog signal received into a digital signal.

FIG.1

FIG.2

FIG.3

FIG.4